# EUROPEAN PATENT APPLICATION

(11) **EP 4 617 675 A1**
(43) Date of publication of application: **17.09.2025**
(21) Application number: 23888572.7
(22) Date of filing: 31.10.2023
(51) Int. Cl.: G01R 1/067, G01R 1/073

(54) **PROBE AND ELECTRICAL CONNECTING DEVICE**

(30) Priority: 11.11.2022 JP 2022180871
(71) Applicant: Kabushiki Kaisha Nihon Micronics, Musashino-shi Tokyo 180-8508 (JP)
(72) Inventor: NASU Mika, Musashino-shi, Tokyo 180-8508 (JP); TOYODA Misaki, Musashino-shi, Tokyo 180-8508 (JP); HAYASHIZAKI Takayuki, Musashino-shi, Tokyo 180-8508 (JP); TAKASE Minako, Musashino-shi, Tokyo 180-8508 (JP)
(74) Representative: Samson & Partner Patentanwälte mbB
(86) International application number: PCT/JP2023/039278
(87) International publication number: WO 2024/101224

(57) **Abstract**

A probe includes: a base material with a column shape that includes a first end, a second end, and a cross section with a polygonal shape perpendicular to an axial direction; and a contact film that covers a tip surface of the second end, and remaining side surfaces of the second end obtained by excluding a side surface facing a first direction from a plurality of side surfaces connected to the tip surface of the second end. An end surface of the contact film that covers the tip surface of the second end is a plain surface orthogonal to the axial direction.

## Description

### TECHNICAL FIELD

The present invention relates to a probe and an electrical connection apparatus used for inspecting electrical characteristics of an object to be inspected.

### BACKGROUND ART

An electrical connection apparatus having a probe is used for inspecting electrical characteristics of an object to be inspected such as a semiconductor integrated circuit in a wafer state. In the inspection using the probe, one end of the probe contacts an electrode of the object to be inspected, and the other end of the probe contacts a terminal arranged on a printed board or the like (hereinafter referred to as "land"). The land is electrically connected to an inspection device such as a tester.

### CITATION LIST

### PATENT LITERATURE

Patent Literature 1: JP 2015-118064 A

### SUMMARY OF INVENTION

### PROBLEMS TO BE SOLVED BY INVENTION

In order to accurately inspect electrical characteristics of an object to be inspected, it is necessary that a probe is in stable contact with a land. An object of the present invention is to provide a probe and an electrical connection apparatus that can make stable contact with a land.

### SOLUTION TO SOLVE PROBLEMS

A probe according to one aspect of the present invention includes: a base material with a column shape that includes a first end, a second end, and a cross section with a polygonal shape perpendicular to an axial direction; and a contact film that covers a tip surface of the second end, and remaining side surfaces of the second end obtained by excluding a side surface facing a first direction from a plurality of side surfaces connected to the tip surface of the second end. An end surface of the contact film that covers the tip surface of the second end is a plain surface orthogonal to the axial direction.

### EFFECTS OF INVENTION

According to the present invention, it is possible to provide a probe and an electrical connection apparatus that can make stable contact with a land.

### BRIEF DESCRIPTION OF DRAWINGS

[FIG. 1] FIG. 1 is a schematic view showing a configuration of a probe according to an embodiment of the present invention.
[FIG. 2] FIG. 2 is a schematic cross-sectional view which is taken along **II-II** direction in FIG. 1.
[FIG. 3] FIG. 3 is a schematic perspective view showing a configuration of a second end of the probe according to the embodiment of the present invention.
[FIG. 4] FIG. 4 is a schematic perspective view showing a configuration of the second end of the probe according to the embodiment of the present invention.
[FIG. 5] FIG. 5 is a schematic view showing a configuration of an electrical connection apparatus according to the embodiment of the present invention.
[FIG. 6] FIG. 6 is a schematic view showing a state in which a land is in contact with a probe of a first comparative example.
[FIG. 7] FIG. 7 is a schematic view showing a state in which a land is in contact with a probe according to the embodiment of the present invention.
[FIG. 8] FIG. 8 is a schematic view showing a state in which adjacent probes having no tapered shape are arranged.
[FIG. 9] FIG. 9 is a schematic view showing a state in which adjacent probes having tapered shapes are arranged.
[FIG. 10] FIG. 10 is a schematic perspective view showing a configuration of a second end of a probe of a second comparative example.

### DESCRIPTION OF EMBODIMENTS

An embodiment of the present invention will be described with reference to the drawings. In the description of the drawings below, the same or similar parts are denoted with the same or similar reference numerals. However, it should be noted that the drawings are schematically shown and the ratios of the thickness of each portion and the like are different from those in reality. Further, it is needless to say that the drawings include portions where the relationships and ratios of dimensions are different between drawings. The following embodiment exemplifies an apparatus and a method for embodying the technical concept of the present invention, and the embodiment of the present invention does not specify the material, shape, structure, arrangement, manufacturing method, and the like of components to the following.

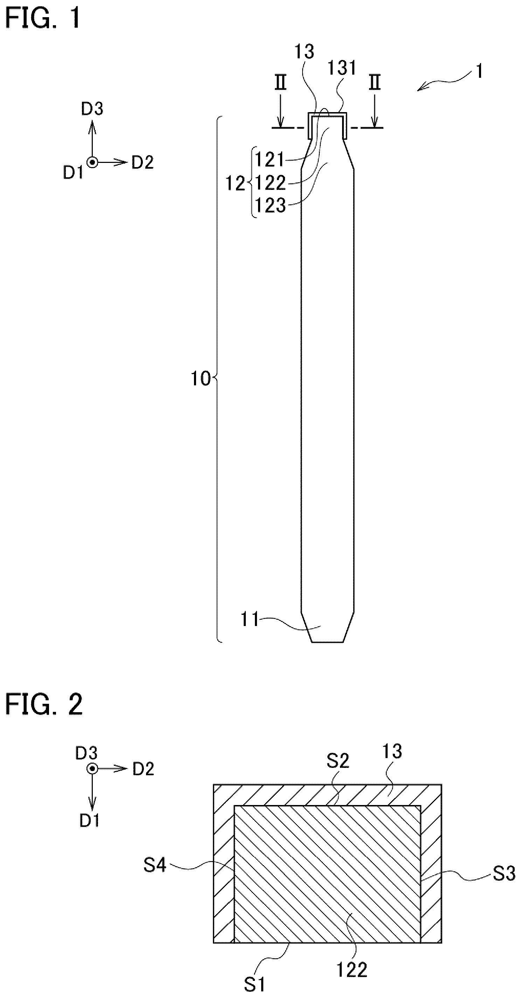

A probe 1 according to an embodiment shown in FIG. 1 is used for inspecting electrical characteristics of an object to be inspected. The probe 1 includes a base material 10 having a first end 11 which is one end in contact with the object to be inspected (not shown) when inspection is performed and a second end 12 which is the other end, and a contact film 13 which covers a portion of the second end 12 of the base material 10. The base material 10 has a column shape extending in an axial direction D3. When the object to be inspected is inspected, the second end 12 contacts a land.

The base material 10 has a polygonal cross section (hereinafter simply referred to as "cross section") perpendicular to the axial direction D3. Hereinafter, as shown in FIG. 2, a case where the cross section of the base material 10 has a rectangular shape will be described as an example. The second end 12 has four side surfaces connected to a tip surface 121. That is, the second end 12 has a first side surface S1 facing a first direction D1, a second side surface S2 facing an opposite direction of the first direction D1, a third side surface S3 facing a second direction D2 perpendicular to the first direction D1, and a fourth side surface S4 facing an opposite direction of the second direction D2. Hereinafter, when the first side surface S1 to the fourth side surface S4 are not limited, they are collectively referred to as side surfaces S.

The contact film 13 covers the tip surface 121 of the second end 12, and the three remaining side surfaces of the second end 12 obtained by excluding the side surface facing the first direction D1 from the plurality of side surfaces connected to the tip surface 121 of the second end 12. As shown in FIGS. 2, 3, and 4, the contact film 13 covers the remaining three side surfaces S, of a region of the second end 12 (hereinafter referred to as "tip region 122"), which are connected to the tip surface 121 and are obtained by excluding the first side surface S1 facing the first direction D1 from the four side surfaces. That is, the contact film 13 of the probe 1 with the rectangular cross section covers the second side surface S2, the third side surface S3, and the fourth side surface S4 of the tip region 122. Further, as shown in FIG. 1, the contact film 13 covers the tip surface 121 of the second end 12. An end surface 131 of the contact film 13 covering the tip surface 121 of the second end 12 is a plain surface orthogonal to the axial direction D3.

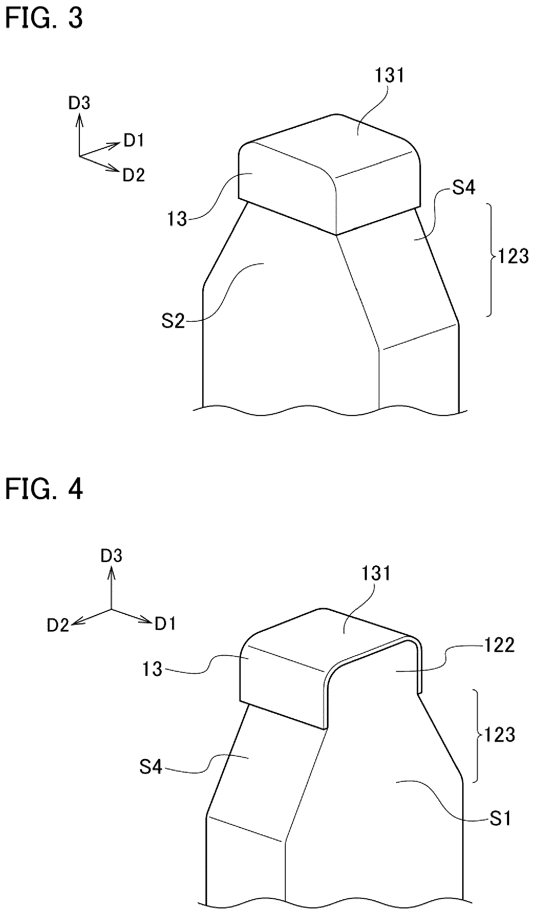

As shown in FIGS. 3 and 4, it is preferable that corners of the end surface 131 of the contact film 13 are chamfered. When viewed from the first direction D1, connection portions between the outer side surfaces and the end surface 131 of the contact film 13 shown in FIGS. 3 and 4 are round-chamfered.

The tip surface 121 of the second end 12 is the plain surface orthogonal to the axial direction D3. Further, in side view viewed from the first direction D1 and the second direction D2, the tip region 122 covered with the contact film 13 has a rectangular shape. Therefore, the end surface 131 of the contact film 13 covering the tip surface 121 of the second end 12 is a plain surface, and a portion of the contact film 13 covering the side surfaces S of the second end 12 is orthogonal to the end surface 131.

Although a reason will be described later, it is preferable that a region of the second end 12 which is exposed to the outside of the contact film 13 and is connected to the tip region 122 (hereinafter referred to as "connection region") has a tapered shape in which a cross section of the base material 10 gradually narrows toward the tip surface 121. In FIGS. 3 and 4, when viewed from the first direction D1, extended portions of the third side surface S3 and the fourth side surface S4 of a connection region 123, which are outer side surfaces S, cross the tip surface 121 by forming an obtuse angle. Hereinafter, the side surfaces S of the connection region 123 where the extended portions cross the tip surface 121 by forming an obtuse angle are also referred to as "tapered side surfaces".

In order to electrically connect an electrode of the object to be inspected to the land, conductive materials such as metal materials are used for the base material 10 and the contact film 13. The contact film 13 may be formed on a surface of the base material 10 by means of plating, for example.

It is preferable to select materials of the base material 10 and the contact film 13 such that the electrical conductivities of the base material 10 and the contact film 13 are equal, or the electrical conductivity of the contact film 13 is higher than that of the base material 10. By selecting materials of the base material 10 and the contact film 13 in this way, it is possible to reduce the electrical resistance between the probe 1 and the land. The following are suitably used for the base material 10: nickel (Ni), a nickel alloy, gold (Au), silver (Ag), copper (Cu), palladium (Pd), a palladium alloy, rhodium (Rh), a rhodium alloy, and other precious metals, for example. Gold (Au), silver (Ag), copper (Cu), other precious metals, and the like are suitably used for the contact film 13.

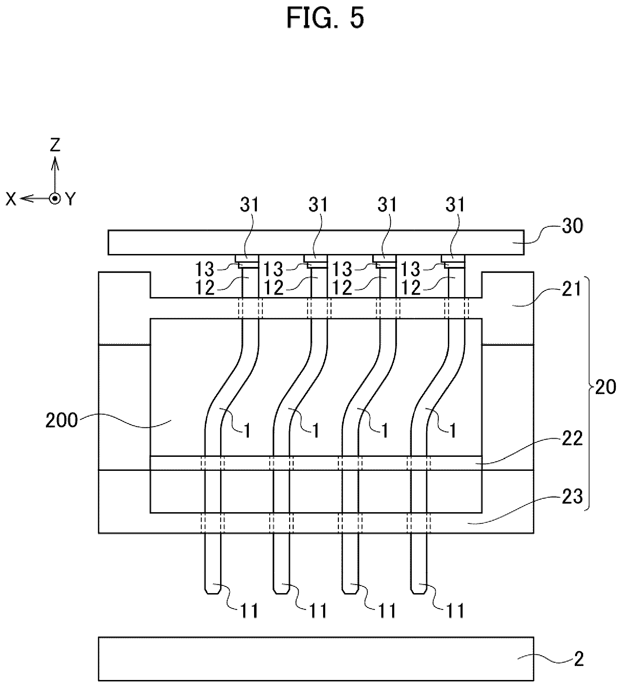

A plurality of probes 1 are used in an electrical connection apparatus 100 shown in FIG. 5, for example. In the electrical connection apparatus 100, the probes 1 are held by a probe head 20. Specifically, the probes 1 are inserted into guide holes in a first guide plate 21, a second guide plate 22, and a third guide plate 23 included in the probe head 20, and are held by the probe head 20. Hereinafter, when the first guide plate 21, the second guide plate 22, and the third guide plate 23 are not limited, they are collectively referred to as guide plates. The probe head 20 has a configuration in which the first guide plate 21, the second guide plate 22, and the third guide plate 23 are separated from each other in a direction normal to a main surface of the guide plate (Z direction).

Each first end 11 of each probe 1 contacts an electrode pad (not shown) of the object to be inspected 2, when the object to be inspected 2 is inspected. Each contact film 13 covering each tip region 122 of each second end 12 of each probe 1 contacts each land 31 of a substrate 30. The lands 31 are electrically connected to an inspection device such as an IC tester (not shown).

As shown in FIG. 5, among the guide holes through which the same probe 1 passes, a position of the guide hole in the first guide plate 21 is shifted in a -X direction, relative to a position of the guide hole in the second guide plate 22, and the -X direction is a direction parallel to a main surface of the second guide plate 22. FIG. 5 is a side view viewed from a Y direction orthogonal to both an X direction and the Z direction. Hereinafter, an arrangement in which positions of the guide holes are shifted will be referred to as an "offset arrangement". Further, a direction in which the positions of the guide holes are shifted will be referred to as an "offset direction". In FIG. 5, the offset direction is the -X direction. Due to the offset arrangement, the base materials 10 of the probes 1 are curved inside the probe head 20. That is, in a hollow region 200 between the first guide plate 21 and the second guide plate 22, the base materials 10 are curved due to elastic deformation. The position of the guide hole in the second guide plate 22 and a position of the guide hole in the third guide plate 23 are aligned, when viewed from the Z direction.

Since the guide hole in the first guide plate 21 and the guide hole in the second guide plate 22 are arranged to achieve the offset arrangement, when each first end 11 of each probe 1 contacts the object to be inspected 2, each probe 1 buckles in the hollow region 200. That is, in a contact state where each probe 1 contacts the object to be inspected 2, each probe 1 further curves, due to deflection deformation, from a curved shape in a non-contact state where each probe 1 does not contact the object to be inspected 2. Due to each probe 1 being further curved, each probe 1 contacts the object to be inspected 2 by a predetermined pressure. Therefore, by achieving the offset arrangement, it is possible to stably measure electrical characteristics of the object to be inspected 2 using each probe 1. When each probe 1 is in the non-contact state, each probe 1 has elasticity in which a shape of each probe 1 returns to a shape before each probe 1 contacts the object to be inspected 2.

Each probe 1 is attached to the probe head 20 such that the first direction D1 and the offset direction are in the same direction. In other words, each first side surface S1 of of each second end 12, which is not covered with each contact film 13, faces the same direction as the offset direction. Therefore, as described below, it is possible to suppress each probe 1 from contacting a land different from a predetermined contact target land (hereinafter referred to as "target land").

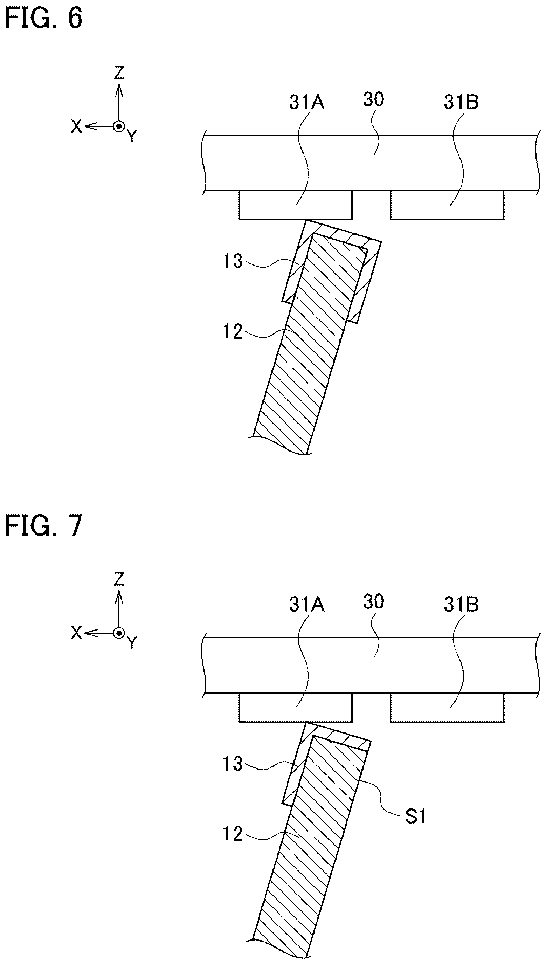

A probe of a first comparative example in which all of the side surfaces S of the second end 12 are covered with the contact film 13 will be investigated below. As shown in FIG. 6, due to the offset arrangement, the second end 12 tends to tilt obliquely relative to the Z direction. At this time, in the probe of the first comparative example in which all of the side surfaces S of the second end 12 are covered with the contact film 13, when land distances of the substrate 30 are small, the contact film 13 covering the second end 12 approaches a land which is adjacent to a target land 31A in the offset direction (hereinafter also referred to as "adjacent land"). Therefore, there is a risk that the contact film 13 may contact an adjacent land 31B. In particular, when a position of the second end 12 is shifted in parallel with the X direction, contact between the contact film 13 and the adjacent land 31B is likely to occur.

Meanwhile, in the probe 1 having the first side surface S1 not covered with the contact film 13, as shown in FIG. 7, it is possible to ensure a large distance between the contact film 13 and the adjacent land 31B. Therefore, according to the probe 1, it is possible to suppress the contact between the probe 1 and the adjacent land 31B.

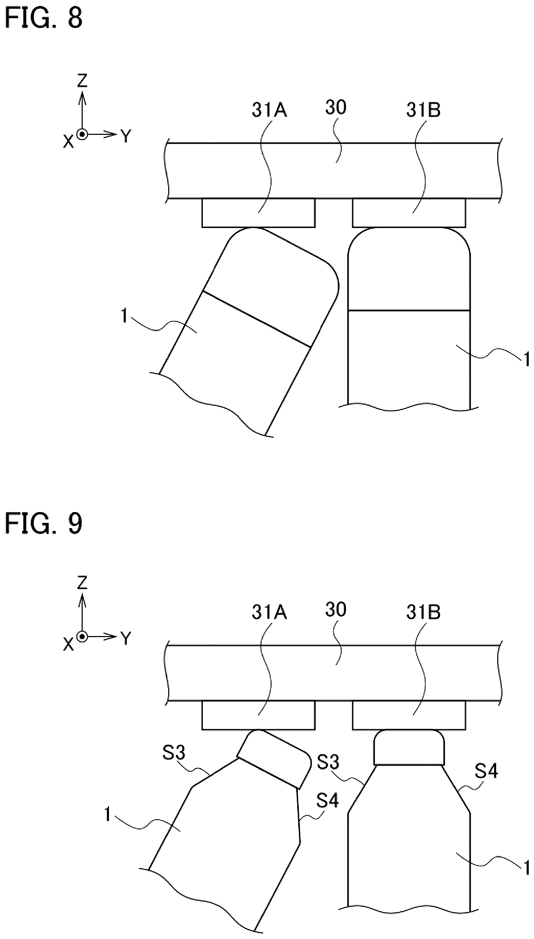

In this way, the probe 1 tends to tilt in the offset direction due to being affected by the offset arrangement. Further, clearances are formed between the probe 1 and the guide holes in an XY direction individually. Therefore, the probe 1 may tilt in a direction orthogonal to the offset direction, that is, in the Y direction. As shown in FIG. 8, when the probe 1 is tilted in the Y direction, the probe 1 approaches an adjacent probe 1. Therefore, it is preferable that the third side surface S3 and the fourth side surface S4 facing the Y direction are set as tapered side surfaces, and the connection region 123 of the second end 12 has a tapered shape. Due to the connection region 123 of the second end 12 having a tapered shape, contact between adjacent probes 1 can be suppressed, as shown in FIG. 9. Furthermore, due to the connection region 123 having a tapered shape, the contact area of the end surface 131 can be made smaller than the cross-sectional area of the base material 10. Therefore, it is possible to increase the pressing force of the probe 1 for pressing the land 31, and enhance the contact stability between the probe 1 and the land 31.

A case where the third side surface S3 and the fourth side surface S4 are tapered side surfaces has been described as an example. However, any side surface S of the connection region 123 can be made to be a tapered side surface. All of the side surfaces S of the connection region 123 may be made to be tapered side surfaces, for example. As a result, even if the probe 1 is tilted in any direction, contact between the adjacent probes 1 can be suppressed. Alternatively, only one side surface S facing a direction, in which the probe 1 tends to be tilted, may be made to be a tapered side surface. This can reduce the manufacturing process of the probe 1. Even if any side surface S is made to be a tapered side surface, by reducing the area of the tip surface 121 of the second end 12, even if the position shift of the probe 1 occurs, contact between the adjacent probes 1 can be suppressed.

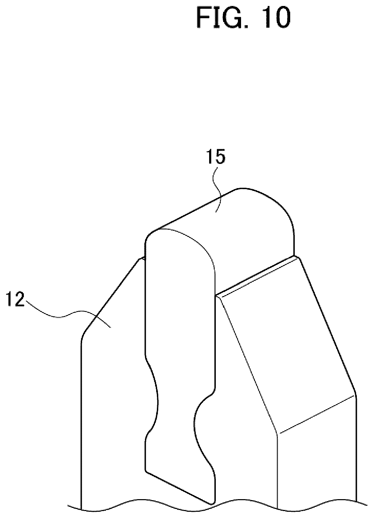

As described above, the tip region 122 of the second end 12 of the probe 1 is covered with the contact film 13, and the end surface 131 of the contact film 13 is a plain surface. Therefore, the probe 1 can stabilize the contact between the second end 12 and the land, compared with a probe of a second comparative example shown in FIG. 10, in which a contact member 15 that contacts the land is embedded in the second end 12. That is, in the probe of the second comparative example, the contact with the land is a point contact. Meanwhile, in the probe 1, in which the tip region 122 of the second end 12 is covered with the contact film 13, the contact with the land is a surface contact. This stabilizes the contact between the probe 1 and the land. As a result, it is possible to implement favorable energization between the object to be inspected and the land.

Further, in the probe of the second comparative example shown in FIG. 10, after contact with the land is repeated, the contact member 15 is deformed, and the total length of the probe is reduced. As a result, a clearance is formed between the probe and the land, and contact failure between the probe and the land tends to occur. Meanwhile, in the electrical connection apparatus 100 having the probe 1 in which the tip region 122 of the second end 12 is covered with the contact film 13, deformation of the tip region 122 can be suppressed. This can prevent the contact failure between the probe 1 and the land. In addition, in the probe 1, by covering the second end 12 of the base material 10 with the contact film 13, adjustment of the film composition and film thickness becomes relatively easy. This can increase the degree of design freedom of the probe 1. Still further, in the probe 1, all of the side surfaces S connected to the end surface 131 are orthogonal to the end surface 131. Therefore, compared to a tapered shape in which the cross section of the base material becomes wider, as the side surfaces S are further away from the end surface 131, the plated contact film 13 is prevented from peeling off from the base material 10, for example. This can enhance the durability of the probe 1. Especially, since the contact film 13 of the probe 1 repeatedly contacts the land, the contact film 13 is required to have durability. However, since all of the side surfaces S are orthogonal to the end surface 131, the contact film 13 is hardly peeled off, and the durability of the probe 1 can be enhanced.

As described above, in the probe 1 according to the embodiment of the present invention, the tip region 122 of the second end 12 is covered with the contact film 13 having the end surface 131 which is a plain surface. Therefore, according to the probe 1, it is possible to stably contact the land and the second end 12. Further, in the electrical connection apparatus 100 having the probe 1, the contact film 13 is not disposed on the first side surface S1 of the tip region 122 parallel to the offset direction of the probe 1. Therefore, according to the electrical connection apparatus 100, it is possible to suppress the probe 1 from contacting adjacent lands. Still further, according to the electrical connection apparatus 100 having the probe 1 in which the connection region 123 has a tapered shape, the contact between the adjacent probes 1 can be suppressed.

### (Other embodiments)

Although an embodiment of the present invention has been described above, the discussion and drawings forming part of this disclosure should not be construed as limiting the invention. Various alternative embodiments, examples, and operational techniques will be apparent to those skilled in the art from this disclosure.

In the above description, the cross section of the probe 1 has a rectangular shape, but the cross section of the probe 1 may have other shapes, for example. The cross section of the probe 1 may have a polygonal shape other than a rectangular shape, for example. Even if the cross section of the probe 1 has any polygonal shape, if a side surface of the probe 1 in an opposite direction of the offset direction is not covered with the contact film 13, it is possible to suppress the probe 1 from contacting the adjacent lands.

In addition, in the above description, the connection region 123 is connected to the tip region 122 of the probe 1 covered with the contact film 13, but it is not necessary for the contact film 13 to cover an entirety of the tip region 122. A surface, which is connected to the end surface 131 and on which the contact film 13 is not formed, may be placed on the opposite side of a surface on which the contact film 13 is formed in the tip region 122, for example. The connection region 123 with a tapered shape may be connected to the surface on which the contact film 13 is not formed.

In this way, it is needless to say that the present invention includes various embodiments not described above.

### REFERENCE SIGNS LIST

- 1: Probe
- 10: Base material
- 11: First end
- 12: Second end
- 13: Contact film
- 20: Probe head
- 21: First guide plate
- 22: Second guide plate
- 23: Third guide plate
- 30: Substrate
- 31: Land
- 100: Electrical connection apparatus
- 121: Tip surface
- 122: Tip region
- 123: Connection region
- 131: End surface
- S1: First side surface
- S2: Second side surface
- S3: Third side surface
- S4: Fourth side surface

## Claims

1. A probe used for inspection of an electrical characteristic of an object to be inspected, the probe comprising:
a base material with a column shape that includes a first end in contact with the object to be inspected when the inspection is performed, a second end, and a cross section with a polygonal shape perpendicular to an axial direction; and
a contact film that covers a tip surface of the second end, and remaining side surfaces of the second end obtained by excluding a side surface facing a first direction from a plurality of side surfaces connected to the tip surface of the second end, wherein
an end surface of the contact film that covers the tip surface of the second end is a plain surface orthogonal to the axial direction.

2. The probe according to claim 1, wherein
a corner of the end surface of the contact film is chamfered when viewed from the first direction.

3. The probe according to claim 1, wherein
a region of the second end that is exposed to an outside of the contact film and is connected to a region covered with the contact film has a tapered shape in which the cross section of the base material gradually narrows toward the tip surface.

4. The probe according to claim 1, wherein
the cross section of the base material perpendicular to the axial direction has a rectangular shape.

5. The probe according to claim 1, wherein
an electrical conductivity of the contact film is higher than an electrical conductivity of the base material.

6. An electrical connection apparatus comprising:
a probe head with a configuration in which a first guide plate in which a guide hole is formed and a second guide plate in which a guide hole is formed are separated from each other; and
the probe according to any one of claims 1 to 5 that is inserted into the guide holes and is held by the probe head, wherein
among the guide holes through which the same probe passes, a position of the guide hole in the second guide plate is shifted in an offset direction to achieve an offset arrangement, relative to a position of the guide hole in the first guide plate, and the offset direction is a direction parallel to a main surface of the first guide plate,
the base material is held in a curved state between the first guide plate and the second guide plate, and
the first direction is the offset direction.
